# EUROPEAN PATENT APPLICATION

(11) **EP 4 586 298 A1**
(43) Date of publication of application: **16.07.2025**
(21) Application number: 22960513.4
(22) Date of filing: 25.10.2022
(51) Int. Cl.: H01J 25/50

(54) **MAGNETRON AND MICROWAVE HEATING DEVICE**

(30) Priority: 29.09.2022 CN 202211204105
(71) Applicant: Guangdong Witol Vacuum Electronic Manufacture Co., Ltd, Foshan, Guangdong 528311 (CN)
(72) Inventor: XU, Shibin, Foshan, Guangdong 528311 (CN); HE, Pan, Foshan, Guangdong 528311 (CN); ZHANG, Man, Foshan, Guangdong 528311 (CN); WANG, Xianyou, Foshan, Guangdong 528311 (CN); LIU, Zhiyong, Foshan, Guangdong 528311 (CN); ZHOU, Wei, Foshan, Guangdong 528311 (CN)
(74) Representative: Ran, Handong
(86) International application number: PCT/CN2022/127245
(87) International publication number: WO 2024/065913

(57) **Abstract**

A magnetron and a microwave heating device. The magnetron comprises a tube core (21), a first tube housing (21a), a second tube housing (21b), output ceramic (22), an antenna cap (23), and an antenna (24). The first tube housing (21a), the tube core (21), the second tube housing (21b), the output ceramic (22) and the antenna cap (23) are connected in sequence. The antenna (24) extends into the tube core (21), and sequentially passes through the second tube housing (21b) and the output ceramic (22) and then extends into the antenna cap (23). The height H1 of the second tube housing (21b) relative to the tube core (21) is not greater than 14 millimeters, and the ratio H1/S of the height H1 of the tube core (21) to the cross-sectional area S of the antenna (24) is within the range of 0.4 to 3.3.

## Description

### FIELD

The present application relates to the field of heating device technologies, and in particular, to a magnetron and a microwave heating device including the magnetron.

### BACKGROUND

A magnetron is a vacuum electron tube that generates microwaves. Because of its high oscillation efficiency, high microwave output power, and other characteristics, the magnetron is widely used as a microwave generating source in microwave application devices such as a household microwave oven and an industrial microwave heating device. As a relatively mature microwave generating source, a structure and a size of the magnetron are strictly limited. Therefore, in a device that uses the magnetron to generate microwaves, the magnetron has a large size, which has an adverse impact on a volume of the device.

### SUMMARY

An object of the present application is to provide a magnetron. The magnetron can be miniaturized through redesign of a size of the magnetron, and an impact on output efficiency of the magnetron can be reduced while the magnetron being miniaturized.

Another object of the present application is to provide a microwave heating device. The microwave heating device includes the aforementioned magnetron.

The magnetron according to embodiments of the present application includes a tube core, a first tube shell, a second tube shell, an output ceramic, an antenna cap, and an antenna. The first tube shell, the tube core, the second tube shell, the output ceramic, and the antenna cap are connected in sequence. The antenna extends into the tube core, and sequentially passes through the second tube shell and the output ceramic and extends into the antenna cap. A height H1 of the second tube shell relative to the tube core is smaller than or equal to 14mm, and a ratio H1/S of a height H1 of the tube core to a cross-sectional area S of the antenna ranges from 0.4 to 3.3.

With the magnetron according to the embodiments of the present application, a miniaturization design of the magnetron is realized by reducing a size of the tube core. Moreover, by setting the ratio of the height of the tube core to the height of the output ceramic, the output efficiency of the magnetron can be ensured, and energy loss can be reduced.

In addition, the magnetron according to the embodiments of the present application can further have the following additional technical features.

Optionally, the ratio H1/S of the height H1 of the tube core to the cross-sectional area S of the antenna ranges from 1.5 to 1.7.

Optionally, a height of the first tube shell relative to the tube core is smaller than or equal to the height of the second tube shell relative to the tube core.

Optionally, each of the first tube shell and the second tube shell includes a tube body portion and a plate body portion. The plate body portion covers an end portion of the tube core, and the plate body portion is provided with a protrusion. The protrusion is configured to support a magnetic portion arranged around the tube body portion to allow a gap to be formed between the magnetic portion and the plate body portion.

Optionally, the magnetron further includes a housing and a heat dissipation member. The tube core is disposed inside of the housing, and the heat dissipation member is connected between the tube core and the housing.

Optionally, the heat dissipation member includes a connection portion, a first branch and a second branch. The connection portion is connected to the tube core. The first branch is connected to the connection portion and extends obliquely to be connected to the housing. The second branch is connected to the connection portion and extends obliquely to be connected to the housing. The first branch and the second branch extend obliquely in opposite directions.

Optionally, the connection portion is provided with a first flange attached to an outer surface of the tube core. Each of the first branch and the second branch is provided with a second flange attached to an inner surface of the housing.

Optionally, the antenna is constructed as an elongated strip with a circular, elliptical or rectangular cross-section.

The microwave heating device according to the embodiments of the present application includes an inner container and the magnetron as described above. The inner container has a cooking cavity and a microwave channel formed at a wall of the inner container. The magnetron is disposed outside of the inner container and adapted to provide microwaves into the inner container through the microwave channel.

Optionally, the microwave channel is constructed into a flared shape with a cross-sectional area gradually increasing towards the cooking cavity.

Optionally, the output ceramic and the antenna cap extend into the microwave channel.

### BRIEF DESCRIPTION OF THE DRAWINGS

FIG. 1 is a schematic view of a magnetron according to an embodiment of the present application.
FIG. 2 is a schematic view of a magnetron according to an embodiment of the present application.
FIG. 3 is a schematic partially enlarged view of a circled part A in FIG. 2.
FIG. 4 is a schematic view of a microwave heating device according to an embodiment of the present application.
FIG. 5 is a schematic view of H1/S-output efficiency of a magnetron according to an embodiment of the present application.

Reference numerals:
microwave heating device 100, inner container 10, cooking cavity 101, microwave channel 102, magnetron 20, tube core 21, first tube shell 21a, second tube shell 21b, tube body portion 211, plate body portion 212, protrusion 213, output ceramic 22, antenna cap 23, antenna 24, housing 25, heat dissipation member 26, connection portion 261, first branch 262, second branch 263, first flange 264, second flange 265, magnetic member 27.

### DETAILED DESCRIPTION

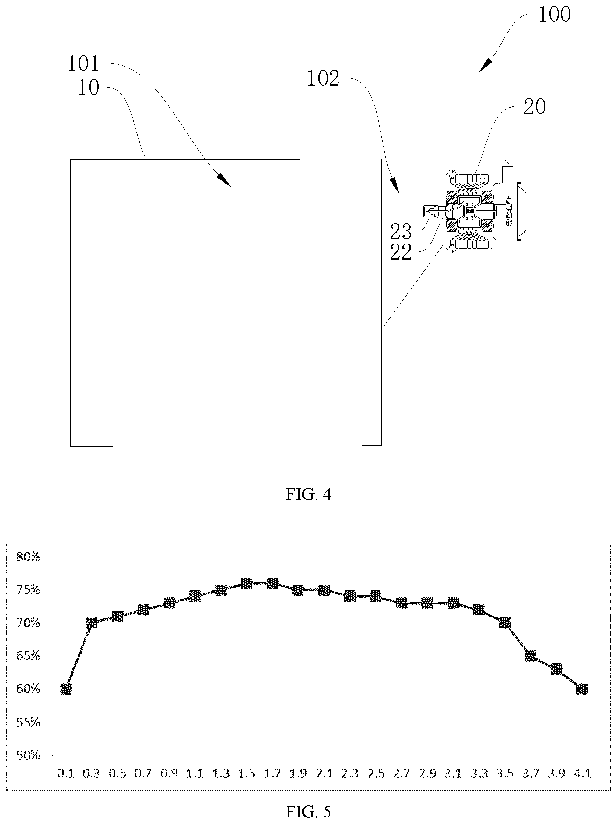

A magnetron is a vacuum electron tube that generates microwaves. Because of its high oscillation efficiency, high microwave output power, and other characteristics, the magnetron is widely used as a microwave generating source in microwave application devices such as a household microwave oven and an industrial microwave heating device. As a main energy source in a microwave heating device, the magnetron has an important effect on the microwave heating device. As can be seen from FIG. 4, the magnetron is mounted in an electrical compartment of a microwave oven and occupies a large space, which is a bottleneck in the miniaturization of the microwave heating device, and seriously limits the development of small-sized and large-capacity microwave heating device. To achieve further miniaturization, it is necessary to reduce a height of the magnetron. However, when the magnetron is miniaturized, it is easy to affect output efficiency of the magnetron, which may cause a waste of energy and easily cause serious heating of the magnetron to affect performance of the magnetron. Therefore, an object of the present application is to overcome the above shortcomings of the prior art and provide a miniaturized magnetron with an energy output structure. Through redesign of a height of an output ceramic, the magnetron has energy output efficiency greater than 70% while its output height is reduced. The miniaturization of an output structure of the magnetron is realized while ensuring high-efficiency energy output. The present application provides a magnetron, which can realize the miniaturization of the magnetron and reduce or avoid an impact on the output efficiency of the magnetron while realizing the miniaturization of the magnetron.

Embodiments of the present application will be described in detail below with reference to examples thereof as shown in the accompanying drawings, throughout which same or similar elements, or elements having same or similar functions, are denoted by same or similar reference numerals. The embodiments described below with reference to the drawings are illustrative only, and are intended to explain rather than limit the present application.

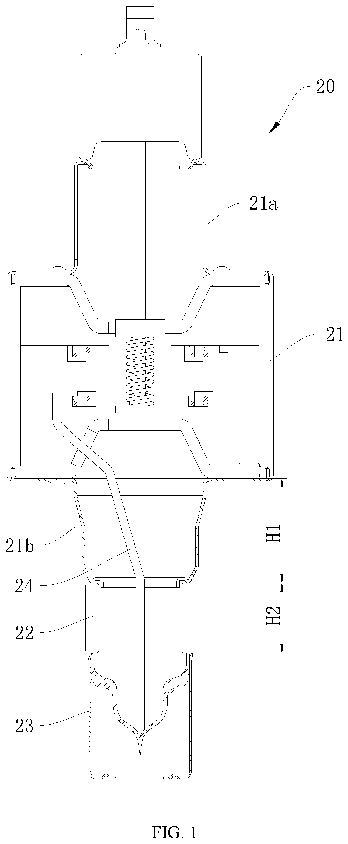

As illustrated in FIG. 1, the magnetron 20 according to the embodiments of the present application includes a tube core 21, a first tube shell 21a, a second tube shell 21b, an output ceramic 22, an antenna cap 23, and an antenna 24. The first tube shell 21a, the tube core 21, the second tube shell 21b, the output ceramic 22, and the antenna cap 23 are connected in sequence. The antenna 24 extends into the tube core 21 and sequentially passes through the second tube shell 21b and the output ceramic 22 and extends into the antenna cap 23. A height H1 of the second tube shell 21b relative to the tube core 21 is smaller than or equal to 14mm, and a ratio H1/S of a height H1 of the tube core 21 to a cross-sectional area S of the antenna 24 ranges from 0.4 to 3.3.

With the magnetron 20 according to the embodiments of the present application, a miniaturization design of the magnetron 20 is realized by reducing a size of the tube core 21. Moreover, by setting the ratio of the height of the tube core 21 to the cross-sectional area S of the antenna 24, the output efficiency of the magnetron 20 can be ensured, and energy loss can be reduced.

The tube core 21, the second tube shell 21b, the output ceramic 22, and the antenna cap 23 may be sequentially arranged in an axial direction of the tube core 21. The antenna 24 passes through the output ceramic 22 along an axis of the output ceramic 22 and extends into the antenna cap 23 along an axis of the antenna cap 23.

As can be seen from FIG. 4, in a microwave heating device 100, in order to realize effective conduction of microwaves, a size of a microwave channel 102 may not be adjusted basically, and the antenna cap 23 or the antenna cap 23 and the output ceramic 22 may be extended into the microwave channel 102 to reduce a space occupied by the magnetron 20. The height H1 of the tube core 21 has a decisive effect on a size of the space occupied by the magnetron 20. Therefore, the present application mainly focuses on the height of the tube core 21 to solve a problem of a large space occupied by the magnetron 20. By setting the height H1 of the tube core 21 to be smaller than or equal to 14mm, the space occupied by the magnetron 20 can be reduced more effectively, thus improving a space utilization rate.

Meanwhile, a reduction in the height H1 of the tube core 21 leads to a large change in a structure of an energy output system of the magnetron 20. In addition, it is difficult for the antenna 24 to transmit energy to the output ceramic 22, which allows the energy output efficiency to be greatly reduced and seriously affects the output efficiency of the magnetron 20.

In order to solve the impact of the reduction in the height H1 of the tube core 21 on the output efficiency of the magnetron 20, a cross-sectional area of the antenna 24 and the height of the first tube shell 21a are reset in the present application. Through experiments, it can be seen that the ratio H1/S of the height H1 of the tube core 21 to the cross-sectional area S of the antenna 24 and the output efficiency of the magnetron 20 show a non-linear change trend. In combination with Table 1 and FIG. 5, it can be seen that when the ratio H1/S ranges from 0.4 to 3.3, the output efficiency of magnetron 20 may be maintained at more than 70%.

**Table 1**

| H1/S | Output efficiency |
|---|---|
| 0.1 | 60% |
| 0.3 | 70% |
| 0.5 | 71% |
| 0.7 | 72% |
| 0.9 | 73% |
| 1.1 | 74% |
| 1.3 | 75% |
| 1.5 | 76% |
| 1.7 | 76% |
| 1.9 | 75% |
| 2.1 | 75% |
| 2.3 | 74% |
| 2.5 | 74% |
| 2.7 | 73% |
| 2.9 | 73% |
| 3.1 | 73% |
| 3.3 | 72% |
| 3.5 | 70% |
| 3.7 | 65% |
| 3.9 | 63% |
| 4.1 | 60% |

Therefore, in the present application, the height H1 of the tube core 21 is set to be smaller than or equal to 14mm, and the ratio H1/S of the height H1 of the tube core 21 to the cross-sectional area S of the antenna 24 is set to range from 0.4 to 3.3, which can not only ensure the miniaturization of the magnetron 20, but also effectively ensure the output efficiency of the magnetron 20, avoid the waste of energy, save energy and protect the environment, and also prevent an excessive heat generation amount of the magnetron 20 from affecting normal operation of the magnetron 20, and improve operation stability of the magnetron 20 after being miniaturized.

As can be seen from the above Table 1, when the height H1 of the tube core 21 is smaller than or equal to 14mm, the H1/S and the output efficiency of the magnetron 20 show a non-linear variation trend. When H1/S ranges from 1.5 to 1.7, the magnetron 20 may be ensured to have higher output efficiency. Therefore, in some embodiments of the present application, the ratio H1/S of the height H1 of the tube core 21 to the cross-sectional area S of the antenna 24 ranges from 1.3 to 1.7. The output efficiency can be further improved while realizing the miniaturization of the magnetron 20.

Further, the ratio H1/S of the height H1 of the tube core 21 to the cross-sectional area S of the antenna 24 may be set to range from 1.4 to 1.6.

In addition, a unit of the height H1 of the tube core 21 may be millimeters, and correspondingly a unit of the cross-sectional area S of the antenna 24 may be square millimeters, in which a unit of the ratio H1/S may be 1/mm. Similarly, the unit of the height H1 of the tube core 21 may be meters, and correspondingly the unit of the cross-sectional area S of the antenna 24 may be square meters, in which the unit of the ratio H1/S may be 1/m or the like.

In some embodiments of the present application, a height of the first tube shell 21a is smaller than a height of the second tube shell 21b, so that a size of the magnetron 20 can be further reduced. In addition, the height of the first tube shell 21a may be set to be the same as the height of the second tube shell 21b, and the heights of the first tube shell 21a and the second tube shell 21b are both heights relative to the tube core 21.

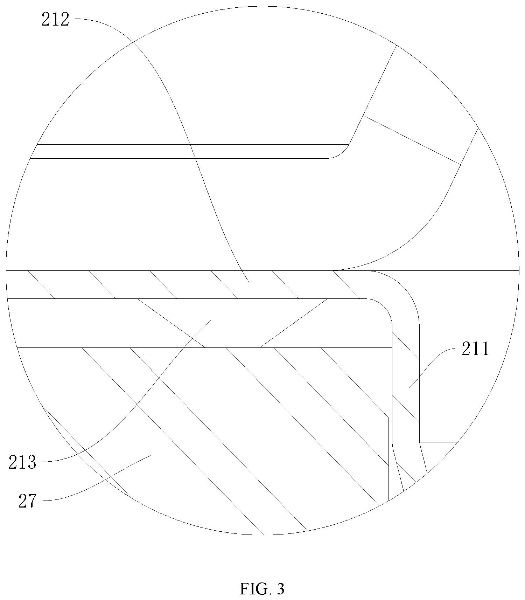

As illustrated in FIG. 3, in some embodiments of the present application, each of the first tube shell 21a and the second tube shell 21b includes a tube body portion 211 and a plate body portion 212. The plate body portion 212 covers an end portion of the tube core 21, and the plate body portion 212 is provided with a protrusion 213. The protrusion 213 is configured to support a magnetic portion arranged around the tube body portion 211 to allow a gap to be formed between the magnetic portion and the plate body portion 212. Through a supporting effect of the protrusion 213, the gap may be formed between a magnetic member 27 and the plate body portion 212. In this way, an airflow can pass through the gap between the magnetic member 27 and the plate body portion 212, thereby taking away heat by itself, which improves heat dissipation efficiency of the magnetic member 27 while reducing a heat transfer rate between the magnetic member 27 and an end housing, and further effectively controls a temperature rise speed and a temperature of the magnetic member 27.

The tube body portion 211 may include two, three or more protrusions 213. For example, a plurality of groups of protrusions 213 may be arranged at intervals in a circumferential direction of the magnetic member 27, and each group of the plurality of groups of protrusions 213 includes at least one protrusion 213. In this way, stable support for the magnetic member 27 can be realized by a plurality of protrusions 213. Meanwhile, it is convenient to form a gap between the magnetic member 27 and an end cover, to increase thermal resistance between the magnetic member 27 and the end cover while improving a heat dissipation effect on the magnetic member 27. In addition, a heat insulation structure may further include a plurality of groups of protrusions 213 concentrically arranged. Each group of the plurality of groups of protrusions 213 includes a plurality of protrusions 213 arranged in the circumferential direction of the magnetic member 27, and two adjacent groups of the plurality of groups of protrusions 213 may have a same number of protrusions 213 or different numbers of protrusions 213, or the like. The applicant of the present application has analyzed a setting number of protrusions 213. As the analysis result of the applicant, when the number of protrusions 213 is 4 or 3, the magnetic member 27 has a slow temperature rise and a lowest magnetic reduction rate. Especially when the number of protrusions 213 is 3, the magnetic member 27 has a slowest temperature rise and the lowest magnetic reduction rate. That is because a least number of protrusions 213 are adopted when three or four protrusions 213 are provided, to provide stable support for the magnetic member 27.

Specifically, the protrusion 213 may be supported within a region from an inner peripheral surface to an outer peripheral surface of the magnetic member 27, preferably at a part with a predetermined ratio of the region from the inner peripheral surface to the outer peripheral surface of the magnetic member 27, and the predetermined ratio may range from 1/3 to 2/3. For example, the protrusion 213 is supported at 1/2 of the region from the inner peripheral surface to the outer peripheral surface of the magnetic member 27. In this way, formation of the gap between the magnetic member 27 and the plate body portion 212 can be further improved, allowing gaps to be stably formed between various parts of the magnetic member 27 and the plate body portion 212, to further weaken heat transfer while further facilitating heat dissipation of the magnetic member 27.

The protrusion 213 is constructed as a truncated cone shape and has a radial size gradually decreasing away from a surface of the plate body portion 212. An end portion periphery of the protrusion 213 is rounded, and/or an end surface of the protrusion 213 is recessed inwards. Therefore, a contact area between the plate body portion 212 and the magnetic member 27 can be further reduced, and a heat conduction rate can be further reduced. Moreover, since there is a gap between the protrusion 213 and the magnetic member 27, circulation of the air flow can be further facilitated for heat dissipation, to improve the heat dissipation effect, and further reduce a temperature rise rate of the magnetic member 27.

In addition, the gap between the magnetic member 27 and the plate body portion 212 may not be set too large or too small, which may affect stable operation of the magnetic member 27. Therefore, in the present application, a protruding height of the protrusion 213 on the surface of the plate body portion 212 ranges from millimeters to millimeters, to allow for formation of a gap ranging from 1mm to 2mm between the magnetic member 27 and the surface of the plate body portion 212. Of course, the gap between the magnetic member 27 and the surface of the plate body portion 212 may be set to be smaller than 1mm or greater than 2mm as actual use situations. Adjustments are performed as actual heat dissipation requirements and energy efficiency requirements. For example, a gap of 0.5mm, 1mm, 2mm, 4mm, 5mm, 10mm, or the like may be formed between the magnetic member 27 and the surface of the plate body portion 212.

In addition, a heat insulation layer may be sprayed on a surface of the magnetic member 27 facing towards the plate body portion 212. By forming a heat insulation layer between the magnetic member 27 and the plate body portion 212, the thermal resistance can be further effectively improved, and the heat transfer rate can be reduced, thereby achieving an effect of reducing the temperature rise rate of the magnetic member 27.

Similarly, an interval between the magnetic member 27 and the plate body portion 212 may not be set too large or too small, which may affect the stable operation of the magnetic member 27. Therefore, a thickness of the heat insulation layer ranges from 1mm to 2mm. Of course, the gap between the magnetic member 27 and the surface of the plate body portion 212 may be set to be smaller than 1mm or greater than 2mm as the actual use situations. The adjustments are performed as the actual heat dissipation requirements and energy efficiency requirements. For example, a gap of 0.5mm, 0.7mm, 2.1mm, 2.3mm, 2.5mm, 3mm, or the like may be formed between the magnetic member 27 and the surface of the plate body portion 212.

In some examples of the present application, the surface of the magnetic member 27 facing towards the plate body portion 212 has a heat insulation layer, the plate body portion 212 has a protrusion 213, and the protrusion 213 abuts with the heat insulation layer. By forming the heat insulation layer and the protrusion 213, it is possible to separate the magnetic member 27 from the plate body portion 212 by a predetermined gap. Moreover, it is also possible to ensure a gap formed between the magnetic member 27 and the plate body portion 212 for the air flow to pass through and to perform heat insulation by utilizing the heat insulation layer, improving the heat insulation and heat dissipation effects, further reducing the temperature rise rate. A total thickness of the heat insulation layer and the protrusion 213 may range from 1mm to 2mm.

In some examples of the present application, the surface of the magnetic member 27 facing towards the plate body portion 212 has a heat insulation layer, and the plate body portion 212 has a protrusion 213. The heat insulation layer covers a part of the surface of the magnetic member 27, and the protrusion 213 abuts with another part of the surface of the magnetic member 27. Similarly, by forming the heat insulation layer and the protrusion 213, it is possible to separate the magnetic member 27 from the plate body portion 212 by the predetermined gap. Moreover, it is also possible to ensure the gap formed between the magnetic member 27 and the plate body portion 212 for the air flow to pass through and to perform heat insulation by utilizing the heat insulation layer, improving the heat insulation and heat dissipation effects, further reducing the temperature rise rate. Each of the thickness of the heat insulation layer and the height of the protrusion 213 may range from millimeters to millimeters.

In some embodiments of the present application, there is a gap between the inner peripheral surface of the magnetic member 27 and an outer peripheral surface of the tube shell. In this way, the magnetic member 27 can be separated from the tube shell, which reduces heat transfer between the tube shell and the magnetic member 27, and further reduces the temperature rise rate of the magnetic member 27. Further, the gap between the inner peripheral surface of the magnetic member 27 and the outer peripheral surface of the tube shell may be empty or filled with the heat insulation layer, or a structure such as a protrusion 213 may be formed between the magnetic member 27 and the tube shell to realize heat insulation.

In the present application, the heat dissipation of the magnetron 20 is redesigned, allowing a temperature rise of a heating surface of a magnet to be greatly reduced. It is also possible to spray a heat insulation coating on the heating surface of the magnet, to reduce heat transfer of a vacuum tube to the magnet.

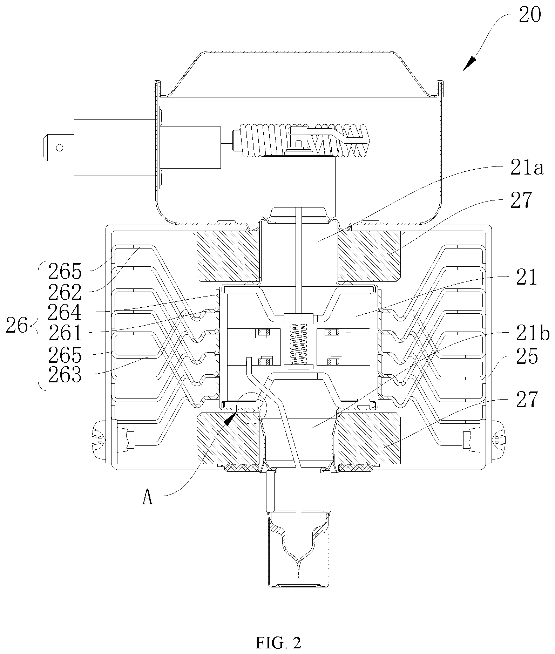

As illustrated in FIG. 2, in some embodiments of the present application, the magnetron 20 further includes a housing 25 and a heat dissipation member 26. The tube core 21 is disposed inside of the housing 25, and the heat dissipation member 26 is connected between the tube core 21 and the housing 25. Through the heat dissipation member 26, effective heat dissipation of the tube core 21 can be realized to provide a stable operation environment for the magnetron 20.

As illustrated in FIG. 2, the heat dissipation member 26 includes a connection portion 261, a first branch 262 and a second branch 263. The connection portion 261 is connected to the tube core 21. The first branch 262 is connected to the connection portion 261 and extends obliquely to be connected to the housing 25. The second branch 263 is connected to the connection portion 261 and extends obliquely to be connected to the housing 25. The first branch 262 and the second branch 263 extend obliquely in opposite directions.

The connection portion 261 is provided with a first flange 264 attached to an outer surface of the tube core 21. Each of the first branch 262 and the second branch 263 is provided with a second flange 265 attached to an inner surface of the housing 25. Heat conduction effects between the heat dissipation member 26 and the tube core 21 and between the heat dissipation member 26 and the housing 25 can be improved, and the heat dissipation effect on the tube core 21 can be further improved.

In some embodiments of the present application, the antenna 24 is constructed as an elongated strip with a circular, elliptical or rectangular cross-section, to facilitate improving microwave conduction efficiency and effects and ensuring the performance of the magnetron 20.

As illustrated in FIG. 1 to FIG. 4, the microwave heating device 100 according to the embodiments of the present application includes an inner container 10 and the magnetron 20 as described above. The inner container 10 has a cooking cavity 101 and a microwave channel 102 formed at a wall of the inner container 10. The magnetron 20 is disposed outside of the inner container 10 and adapted to provide microwaves into the inner container 10 through the microwave channel 102.

As illustrated in FIG. 1 and FIG. 2, the magnetron 20 includes a tube core 21, a heat dissipation system, a magnetic circuit system, a filtering system, an energy output system, and the like. The energy output system includes a second tube shell 21b, an output ceramic 22, an antenna cap 23, an antenna 24, an exhaust tube, and the like. A cross-sectional shape of the antenna 24 is not limited, such as circular, elliptical or rectangular. An end of the antenna 24 is connected to any blade of the tube core 21 (an anode component). Another end of the antenna 24 passes through a hole of the magnetic member 27, passes through the tube shell and the output ceramic 22, and finally is connected to the exhaust pipe. Electromagnetic wave energy generated by the tube core 21 reaches the output ceramic 22 through a structure formed by the tube shell as an outer conductor and the antenna 24 as an inner conductor, and the antenna cap 23, as a microwave matching structure, finally outputs the energy to an exterior of the magnetron 20 to complete an energy output process.

A technical solution of the present application is described below. Provided is an energy output system composed of the second tube shell 21b (a metal housing), the output ceramic 22, the antenna cap 23, the antenna 24, and the exhaust pipe. The height H1 of the second tube shell 21b is a distance between a lower surface of the tube core 21 and an upper surface of the output ceramic 22, and S is the cross-sectional area of the antenna 24. When the height H1 of the second tube shell 21b is smaller than 14mm, the cross-sectional area S of the antenna 24 and the height H1 of the second tube shell 21b are synchronously changed to solve a problem of efficiency decrease caused by a decrease in the height of the second tube shell 21b, improving the output efficiency of the magnetron 20. Specifically, when the height H1 of the second tube shell 21b is smaller than 14mm, the ratio H1/S of the height H1 of the second tube shell 21b to the cross-sectional area S of the antenna 24 is greater than 0.4 and smaller than 3.3, which can realize that the output efficiency is greater than 70%. In addition, a ratio of the height H1 of the tube core 21 to a height H2 of the output ceramic 22 may also range from 0.4 to 2.3. For example, the ratio H1/ H2 of the height H1 of the tube core 21 to the height H2 of the output ceramic 22 may be set to range from 1.4 to 1.6.

With the microwave heating device 100 according to the embodiments of the present application, by providing the foregoing magnetron 20, it is possible to reduce the space occupied by the magnetron 20, realize the miniaturization of the microwave heating device 100 or increase a volume of the cooking cavity 101, and ensure heating performance of the magnetron 20, i.e., on the basis of ensuring the miniaturization and a large volume of the microwave heating device 100, it is possible to improve an energy utilization rate, reduce the waste of energy, and save energy and protect the environment.

As illustrated in FIG. 4, in some embodiments of the present application, the microwave channel 102 is constructed into a flared shape with a cross-sectional area gradually increasing towards the cooking cavity 101, to facilitate transporting more microwaves into the inner container 10, effectively improving heating efficiency of the microwave heating device 100.

As illustrated in FIG. 1, in some embodiments of the present application, the output ceramic 22 and the antenna cap 23 extend into the microwave channel 102, which can improve the microwave transmission efficiency and effects, and can reduce the space occupied by the magnetron 20 and improve the space utilization rate.

In addition, the terms "first" and "second" are only used for descriptive purposes, and cannot be understood as indicating or implying relative importance or implicitly indicating the number of indicated technical features. Therefore, the features associated with "first" and "second" may explicitly or implicitly include at least one of the features. In the description of the present application, "plurality" means at least two, such as two, three, etc., unless otherwise specifically defined.

In the present application, unless otherwise clearly specified and limited, terms such as "install", "connect", "connect to", "fix" and the like should be understood in a broad sense. For example, it may be a fixed connection or a detachable connection or connection as one piece; mechanical connection or electrical connection; direct connection or indirect connection through an intermediate; internal communication of two components or the interaction relationship between two components. For those of ordinary skill in the art, the specific meanings of the above terms in the present application can be interpreted depending on specific situations.

In the present application, unless expressly stipulated and defined otherwise, the first feature "on" or "under" the second feature may mean that the first feature is in direct contact with the second feature, or the first and second features are in indirect contact through an intermediate. Moreover, the first feature "above" the second feature may mean that the first feature is directly above or obliquely above the second feature, or simply mean that the level of the first feature is higher than that of the second feature. The first feature "below" the second feature may mean that the first feature is directly below or obliquely below the second feature, or simply mean that the level of the first feature is smaller than that of the second feature.

In descriptions of the present application, descriptions with reference to the terms "an embodiment", "some embodiments", "examples", "specific examples", or "some examples" etc., mean that specific features, structure, materials, or characteristics described in conjunction with the embodiment or example are included in at least one embodiment or example of the present application. In this specification, the schematic representations of the above terms do not necessarily refer to the same implementation or example. Moreover, the described specific features, structures, materials or characteristics may be combined in any one or more embodiments or examples in a suitable manner. In addition, those skilled in the art can combine the different embodiments or examples and the features of the different embodiments or examples described in this specification without contradicting each other.

Although the embodiments of the present application have been shown and described above, it can be understood that the above-mentioned embodiments are exemplary and should not be construed as limiting the present application. For those of ordinary skill in the art, changes, modifications, substitutions, and variations can be made to the above-mentioned embodiments within the scope of the present application.

## Claims

1. A magnetron, comprising a tube core (21), a first tube shell (21a), a second tube shell (21b), an output ceramic (22), an antenna cap (23), and an antenna (24), wherein:
the first tube shell (21a), the tube core (21), the second tube shell (21b), the output ceramic (22), and the antenna cap (23) are connected in sequence;
the antenna (24) extends into the tube core (21), and sequentially passes through the second tube shell (21b) and the output ceramic (22) and extends into the antenna cap (23);
a height H1 of the second tube shell (21b) relative to the tube core (21) is smaller than or equal to 14 mm; and
a ratio H1/S of a height H1 of the tube core (21) to a cross-sectional area S of the antenna (24) ranges from 0.4 to 3.3.

2. The magnetron according to claim 1, wherein the ratio H1/S of the height H1 of the tube core (21) to the cross-sectional area S of the antenna (24) ranges from 1.5 to 1.7.

3. The magnetron according to claim 1 or 2, wherein the height of the first tube shell (21a) relative to the tube core (21) is smaller than or equal to the height of the second tube shell (21b) relative to the tube core (21).

4. The magnetron according to any one of claims 1 to 3, wherein each of the first tube shell (21a) and the second tube shell (21b) comprises:
a tube body portion (211); and
a plate body portion (212) covering an end portion of the tube core (21), and provided with a protrusion (213), the protrusion (213) being configured to support a magnetic portion arranged around the tube body portion (211) to allow a gap to be formed between the magnetic portion and the plate body portion (212).

5. The magnetron according to any one of claims 1 to 4, further comprising:
a housing (25), the tube core (21) being disposed inside of the housing (25); and
a heat dissipation member (26) connected between the tube core (21) and the housing (25), and comprising a connection portion (261), a first branch (262) and a second branch (263), wherein:
the connection portion (261) is connected to the tube core (21);
the first branch (262) is connected to the connection portion (261) and extends obliquely to be connected to the housing (25);
the second branch (263) is connected to the connection portion (261) and extends obliquely to be connected to the housing (25); and
the first branch (262) and the second branch (263) extend obliquely in opposite directions.

6. The magnetron according to claim 5, wherein:
the connection portion (261) is provided with a first flange (264) attached to an outer surface of the tube core (21); and
each of the first branch (262) and the second branch (263) is provided with a second flange (265) attached to an inner surface of the housing (25).

7. The magnetron according to any one of claims 1 to 6, wherein the antenna (24) is constructed as an elongated strip with a circular, elliptical or rectangular cross-section.

8. A microwave heating device, comprising:
an inner container (10) having a cooking cavity (101) and a microwave channel (102) formed at a wall of the inner container (10); and
the magnetron (20) according to any one of claims 1 to 7, disposed outside of the inner container (10) and adapted to provide microwaves into the inner container (10) through the microwave channel (102).

9. The microwave heating device according to claim 8, wherein the microwave channel (102) is constructed into a flared shape with a cross-sectional area gradually increasing towards the cooking cavity (101).

10. The microwave heating device according to claim 8 or 9, wherein the output ceramic (22) and the antenna cap (23) extend into the microwave channel (102).
